(19) Europäisches Patentamt

European Patent Office

Office européen des brevets

(11) **EP 1 001 268 A2**

(12) **EUROPÄISCHE PATENTANMELDUNG**

(43) Veröffentlichungstag:
**17.05.2000 Patentblatt 2000/20**

(51) Int. Cl.⁷: **G01R 15/24**

(21) Anmeldenummer: **99122411.4**

(22) Anmeldetag: **10.11.1999**

(84) Benannte Vertragsstaaten:
**AT BE CH CY DE DK ES FI FR GB GR IE IT LI LU MC NL PT SE**
Benannte Erstreckungsstaaten:
**AL LT LV MK RO SI**

(30) Priorität: **16.11.1998 DE 19852753**

(71) Anmelder:
**SIEMENS AKTIENGESELLSCHAFT**
**80333 München (DE)**

(72) Erfinder: **Krämmer, Peter, Dr.**
**91052 Erlangen (DE)**

(54) **Verfahren und Einrichtung zur Messung einer elektrischen Spannung mit Hilfe des Pockelseffektes**

(57) Bei dem Verfahren zur Messung einer elektrischen Spannung mit Hilfe des longitudinalen Pockelseffektes wird in einen Pockelskristall (12) zumindest ein polarisierter Lichtstrahl (4,6) eingekoppelt. Gemäß der Erfindung wird der aus dem Pockelskristall (12) austretende erste Lichtstrahl (4a,6a) durch eine jeweils gleiche Anzahl von rechtwinkligen Reflexionen in paarweise senkrecht zueinander orientierten Reflexionsebenen umgelenkt und erneut in den Pockelskristall (12) eingekoppelt.

Fig. 1

**EP 1 001 268 A2**

**Beschreibung**

Die Erfindung bezieht sich auf ein Verfahren und eine Einrichtung zur Messung einer elektrischen Spannung mit Hilfe des Pockelseffektes. Außerdem bezieht sich die Erfindung auf eine insbesondere zur Durchführung des erfindungsgemäßen Verfahrens geeignete Reflexionsanordnung zur polarisationserhaltenden Umlenkung eines Lichtstrahls.

Beim Pockelseffekt handelt es sich um einen Effekt, bei dem in einem Kristall (Pockelskristall) eine lineare Doppelbrechung induziert wird, die proportional zu einem am Kristall angelegten elektrischen Feld ist. Durch die vom elektrischen Feld induzierte lineare Doppelbrechung wird zwischen zwei senkrecht zueinander polarisierten Komponenten eines sich im Pockelskristall fortpflanzenden Lichtstrahls eine Phasenverschiebung induziert, die proportional zu dem Produkt aus der Länge I des Pockelskristalls und der elektrischen Feldstärke E ist. Je nachdem, ob das elektrische Feld E senkrecht oder parallel zur Ausbreitungsrichtung des Lichtstrahls orientiert ist, spricht man vom transversalen bzw. longitudinalen Pockelseffekt.

Die vom Pockelskristall erzeugte Phasenverschiebung zwischen den beiden senkrecht zueinander linear polarisierten Komponenten wird mit Hilfe einer Analysatoreinrichtung gemessen. Diese Phasenverschiebung ist beim longitudinalen Pockelseffekt proportional zum Wegintegral über die Feldstärke und damit proportional zur elektrischen Spannung zwischen der Lichteintrittsfläche und der Lichtaustrittsfläche des Pockelskristalls. Beim transversalen Pockelseffekt ist die Phasenverschiebung proportional zur elektrischen Spannung und proportional zum Weg zwischen der Lichteintrittsfläche und Lichtaustrittsfläche.

Da zu jeder Phasenverschiebung, die größer als $\lambda/2$ ist, zumindest eine Phasenverschiebung existiert, die kleiner als $\lambda/2$ ist und dasselbe Meßergebnis in der Analysatoreinrichtung erzeugt, können ohne weitere Maßnahmen nur elektrische Spannungen eindeutig gemessen werden, die kleiner sind als die zur Phasenverschiebung $\lambda/2$ gehörende sogenannte Halbwellenspannung $V_H$. Diese Halbwellenspannung $V_H$ beträgt beispielsweise für KDP bei einer Wellenlänge von 546 nm etwa 7,6 kV.

Das in den Pockelskristall eingekoppelte Licht ist in der Regel unter 45° zu den senkrecht zur optischen Achse orientierten Hauptachsen des Pockelskristalls linear polarisiert. Für die Intensität des hinter einem in gleicher Weise angeordneten Analysator gemessenen Lichtes gilt nun die Beziehung

$$I = I_0 \cos^2 \varphi/2$$

wobei $\varphi$ die Phasenverschiebung in Bogenmaß ($\lambda/2$ entspricht $\varphi = 180°$), und $I_0$ die hinter dem Analysator gemessene Intensität bei Abwesenheit eines elektrischen Feldes ist.

Wird mit Hilfe des longitudinalen oder transversalen Pockelseffektes eine Wechselspannung gemessen, so kann durch Abzählen der Nulldurchgänge auch eine Wechselspannungsamplitude gemessen werden, die ein Vielfaches der Halbwellenspannung $V_H$ beträgt.

Zur Erhöhung der Genauigkeit der Spannungsmessung und zur eindeutigen Bestimmung der maximalen Amplitude eines Wechselspannungssignals ist es aus der *europäischen Patentanmeldung 0 361 832* bekannt, in den Pockelskristall zwei linear polarisierte Lichtstrahlen einzukoppeln, die gegeneinander um $\lambda/4$ phasenverschoben sind. Dadurch werden zwei zueinander um 45° versetzte Intensitätssignale erzeugt. Ist eines der beiden Intensitätssignale im Bereich minimaler Steigung, d.h. minimaler Empfindlichkeit, so ist das andere Intensitätssignal gerade im Bereich maximaler Steigung oder Empfindlichkeit. Da zwei Intensitätssignale ausgewertet werden, können sowohl die maximalen Spannungsamplituden eindeutig identifiziert werden als auch eine höhere Meßgenauigkeit erzeugt werden.

Bei der Messung hoher Spannungen mit Hilfe des longitudinalen Pockelseffektes liegt jedoch zwischen der Eintrittsfläche und der Austrittsfläche des Pockelskristalls eine hohe Potentialdifferenz an. Da an beide Flächen optische Lichtleitfasern angekoppelt und zu einer Auswerteeinrichtung geführt werden müssen, überbrücken diese ein Gebiet mit hoher Spannungsdifferenz. Dies führt insbesondere unter beengten räumlichen Verhältnissen zu elektrischen Isolationsproblemen.

In der *US-Patentschrift 5,059,894* wird nun zur Vermeidung des vorstehend genannten Nachteils eine reflexive Anordnung vorgeschlagen, bei der das Licht nach Durchquerung des Pockelskristalls in einer Reflexionsanordnung reflektiert und erneut in den Pockelskristall eingekoppelt wird, so daß es diesen ein zweites mal durchquert. Einkoppel- und Auskoppelfläche des Pockelskristalls fallen in dieser Ausführungsform zusammen. Die an den Pockelskristall angekoppelten Lichtleiter befinden sich somit alle auf gleichem Potential, so daß die vorstehend genannten Probleme nicht mehr auftreten.

In dieser US-Patentschrift sind nun zwei alternative Reflexionsanordnungen offenbart. In einer ersten Anordnung werden in den Pockelskristall zwei Lichtstrahlen eingekoppelt, die in einem an der anderen Stirnseite des Pockelskristalls angeordneten Prisma reflektiert werden und den Pockelskristall erneut durchlaufen. Das Prisma ist nun derart angeordnet, daß alle Einfallsebenen des ersten und des zweiten Lichtstrahls auf die spiegelnden Flächen des Prismas parallel zueinander sind. Mit Hilfe von $\lambda/8$-Verzögerungsplatten werden der eingekoppelte erste Lichtstrahl und der aus ihm hervorgehende aus dem Pockelskristall ausgekoppelte reflektierte erste Lichtstrahl um $\lambda/4$ verzögert. Die Komponenten des reflektierten ersten und des reflektierten zweiten Lichtstrahls sind durch die innere Totalreflexion im Prisma ebenfalls zu den Komponenten des einfallenden ersten Lichtstrahls bzw. des zweiten einfallenden Lichtstrahls phasenverschoben. Da diese vom Prisma induzierte Phasenverschiebung für den ersten und zweiten Lichtstrahl gleich ist, bleibt die durch die $\lambda/8$-Verzögerungsplatten eingebrachte relative Phasenverschiebung zwischen dem ersten und zweiten Lichtstrahl konstant und beträgt stets $\lambda/4$. Dies hat aber zur Folge, daß bereits bei Abwesenheit eines elektrischen Feldes eine Phasenverzögerung auftritt, so daß der erste Nulldurchgang, der mit Hilfe der beiden Lichtstrahlen gemessenen Intensitätssignale nicht mehr mit der $\lambda/2$-Spannung $V_H$ zusammenfällt.

In einer ebenfalls aus der US-Patentschrift 5,059,894 bekannten zweiten Anordnung wird an der der Einkoppelfläche gegenüberliegenden Fläche des Pockelskristalls ein pyramidenförmiges Prisma angeordnet. In dieser Ausführungsform ist die Einfallsebene bzw. Reflexionsebene bei der Reflexion des ersten Lichtstrahls im pyramidenförmigen Prisma senkrecht zur Einfalls- bzw. Reflexionsebene des zweiten Lichtstrahls. In diesem Fall haben die Phasenverschiebungen der Komponenten des ersten Lichtstrahls und der Komponenten des zweiten Lichtstrahls entgegengesetztes Vorzeichen, so daß die relative Phasenverschiebung zwischen dem ersten Lichtstrahl und dem zweiten Lichtstrahl geändert wird. Diese relative Phasenverschiebung kann nun durch Auswahl eines geeigneten Materials für das pyramidenförmige Prisma derart eingestellt werden, daß diese $\lambda/4$ oder $3\lambda/4$ beträgt, so daß in dieser Anordnung die $\lambda/8$-Verzögerungsplatten entfallen können. Hierzu ist jedoch ein spezielles Glas erforderlich, das den für diese Phasenverschiebung passenden Brechungsindex hat. Ein solches Glas ist beispielsweise das dort angegebene Schott-Glas LaSFN 18 mit einem Brechungsindex von 1,892, der nahe an dem zur $3\lambda/4$-Verzögerung erforderlichen Brechungsindex von 1,901 liegt.

Der Erfindung liegt nun die Aufgabe zugrunde, ein Verfahren zur Messung einer elektrischen Spannung mit Hilfe des Pockelseffektes anzugeben, das technisch einfach durchgeführt werden kann und bei dem das Auftreten einer unerwünschten Phasenverschiebung bei einer Reflexion eines aus dem Pockelskristall austretenden und erneut in ihn eintretenden Lichtstrahls vermieden ist. Außerdem liegt der Erfindung die Aufgabe zugrunde, eine Einrichtung sowie eine Reflexionsanordnung zur Durchführung des Verfahrens anzugeben.

Hinsichtlich des Verfahrens wird die Aufgabe gemäß der Erfindung gelöst mit den Merkmalen des Patentanspruches 1. Bei dem Verfahren zur Messung einer elektrischen Spannung mit Hilfe des Pockelseffektes wird in einen Pockelskristall zumindest ein polarisierter Lichtstrahl eingekoppelt, wobei der aus dem Pockelskristall austretende Lichtstrahl durch eine jeweils gleiche Anzahl von rechtwinkligen Reflexionen in paarweise senkrecht zueinander orientierten Reflexionsebenen umgelenkt und erneut in den Pockelskristall eingekoppelt wird.

Mit anderen Worten: Der austretende Lichtstrahl wird mehrfach um 90° umgelenkt (reflektiert), wobei jeder Umlenkung (Reflexion) und der durch diese aufgespannten Reflexionsebene (durch die Achse des einfallenden Lichtstrahls und die Achse des reflektierten Lichtstrahls aufgespannte Ebene) eine weitere Unlenkung in einer dazu senkrechten Reflexionsebene zugeordnet ist.

Durch eine solche gleiche Anzahl von Reflexionen in paarweise zueinander senkrechten Reflexionsebenen werden die zwischen den s- und p-Komponenten jeweils auftretenden relativen Phasenverschiebungen aufgehoben, da eine bezüglich der ersten Reflexion vorliegende s-Welle in der zweiten Reflexion als p-Welle reflektiert wird und umgekehrt, so daß die bei der ersten Reflexion zwischen der s- und p-Komponente auftretende Phasenverschiebung bei der zweiten Reflexion kompensiert wird.

In einer bevorzugten Ausgestaltung der Erfindung werden in den Pockelskristall ein erster und ein zweiter polarisierter Lichtstrahl eingekoppelt, wobei der erste und der zweite Lichtstrahl auf ihrem Lichtweg außerhalb des Pockelskristalles relativ zueinander um ein ungeradzahliges Vielfaches von $\lambda/4$ phasenverschoben werden, und wobei der aus dem Pockelskristall austretende erste und zweite Lichtstrahl durch eine jeweils gleiche Anzahl von rechtwinkligen Reflexionen in paarweise senkrecht zueinander orientierten Reflexionsebenen umgelenkt und erneut in den Pockelskristall eingekoppelt werden. Durch diese Maßnahme kann die Meßgenauigkeit erhöht werden.

Relativ zueinander um ein ungeradzahliges Vielfaches von $\lambda/4$ phasenverschoben heißt dabei, daß sich die Phasenverschiebung zwischen den parallel zu den Hauptachsen des Pockelskristalles orientierten Komponenten des ersten Lichtstrahls und die Phasenverschiebung zwischen den parallel zu diesen Hauptachsen orientierten Komponenten des zweiten Lichtstrahls um ein ungeradzahliges Vielfaches von $\lambda/4$ unterscheiden.

Insbesondere sind in jeder Reflexionsebene zwei Reflexionen, vorzugsweise innere Totalreflexionen, vorgesehen. Dadurch werden die bei der Reflexion auftretenden Verluste minimiert.

In einer weiteren vorteilhaften Ausgestaltung des Verfahrens werden in den Pockelskristall ein erster und ein zweiter polarisierter Lichtstrahl eingekoppelt, wobei der erste und der zweite Lichtstrahl auf ihrem Lichtweg außerhalb des Pockelskristalles relativ zueinander durch innere Totalreflexion wenigstens eines der Lichtstrahlen um ein ungeradzahliges Vielfaches von $\lambda/4$ phasenverschoben werden.

Dadurch kann die gewünschte Phasenverschiebung in der zur Umlenkung um 180° vorgesehenen Reflexionsanordnung erzeugt werden, so daß die Anzahl der im Lichtweg angeordneten optischen Elemente reduziert ist, da zusätzliche transmissive Phasenschieber nicht erforderlich sind.

Hinsichtlich der Einrichtung wird die Aufgabe gemäß der Erfindung gelöst durch die Merkmale des Patentanspruches 6. Die Einrichtung zur Messung einer elektrischen Spannung mit Hilfe des longitudinalen Pokkelseffektes enthält einen Pockelskristall und eine diesem vorgeschaltete Sendeeinrichtung zum Erzeugen und Einkoppeln wenigstens eines polarisierten Lichtstrahls in den Pockelskristall, wobei in Ausbreitungsrichtung des Lichtstrahles gesehen hinter dem Pockelskristall eine Reflexionsanordnung vorgesehen ist, die eine Umlenkeinrichtung umfaßt, in der der aus dem Pockelskristall austretende Lichtstrahl zu seinem erneuten Einkoppeln in den Pockelskristall durch eine jeweils gleiche Anzahl von gleichwinkligen Reflexionen in paarweise senkrecht zueinander orientierten Reflexionsebenen umgelenkt wird.

Eine solche Umlenkeinrichtung ist auch für andere Anwendungsfälle geeignet, in denen eine polarisationserhaltende Umlenkung eines Lichtstrahls um 180° gewünscht oder von Vorteil ist.

Als Umlenkeinrichtung ist vorzugsweise ein tetraederförmiges Prisma vorgesehen, das drei zueinander senkrechte und sich in einem Punkt schneidende Grenzflächen und eine zu diesen Grenzflächen unter 45° orientierte weitere Grenzfläche aufweist.

In einer bevorzugten Ausführungsform ist eine dem Pockelskristall vorgeschaltete Sendeeinrichtung zum Erzeugen eines ersten und zweiten polarisierten Lichtstrahls vorgesehen. Außerhalb des Pockelskristalls ist eine transmissive Phasenschieberanordnung zum Erzeugen einer ein ungeradzahliges Vielfaches von $\lambda/4$ betragenden Phasenverschiebung zwischen dem ersten und zweiten Lichtstrahl angeordnet. In Ausbreitungsrichtung des ersten und zweiten Lichtstrahles gesehen sind in der Reflexionsanordnung hinter dem Pockelskristall eine erste und zweite Umlenkeinrichung zum Umlenken des aus dem Pockelskristall austretenden ersten bzw. zweiten Lichtstrahles durch eine jeweils gleiche Anzahl von gleichwinkligen Reflexionen in paarweise senkrecht zueinander orientierten Reflexionsebenen und dessen erneuten Einkoppeln in den Pockelskristall angeordnet.

In einer weiteren vorteilhaften Ausführungsform der Erfindung umfaßt die Einrichtung eine dem Pockelskristall vorgeschaltete Sendeeinrichtung zum Erzeugen eines ersten und zweiten polarisierten Lichtstrahls und eine in Ausbreitungsrichtung der Lichtstrahlen gesehen hinter dem Pockelskristall in der Reflexionsanordnung angeordneten Reflexionsanordnung zum Umlenken und erneuten Einkoppeln des ersten und des zweiten Lichtstrahls in den Pockelskristall. Die Reflexionsanordnung umfaßt eine reflexive Phasenschieberanordnung zum Erzeugen einer ein ungeradzahliges Vielfaches von $\lambda/4$ betragenden Phasenverschiebung zwischen dem ersten und zweiten Lichtstrahl durch eine mehrfache innere Totalreflexion um 180° wenigstens eines der aus dem Pockelskristall austretenden Lichtstrahlen.

Durch die Merkmale des Anspruches 8 wird die Aufgabe hinsichtlich der Reflexionsanordnung gelöst.

Zur weiteren Erläuterung der Erfindung wird auf die Ausführungsbeispiele der Zeichnung verwiesen. Es zeigen:

FIG 1      eine Einrichtung gemäß der Erfindung in einer schematischen perspektivischen Darstellung,

FIG 2      eine bevorzugte Ausführungsform einer hinter dem Pockelskristall angeordneten Umlenkeinrichtung,

FIG 3      eine weitere bevorzugte Ausführungsform gemäß der Erfindung mit einer reflexiven Phasenschieberanordnung ebenfalls in einer schematischen perspektivischen Darstellung,

FIG 4,6      weitere Ausführungsbeispiele für reflexive Phasenschieberanordnungen,

FIG 5,7      zu den Ausführungsbeispielen gemäß FIG 4, 6 bzw. 8 jeweils gehörende Diagramme, in denen die Phasenverschiebung der s- und p-Komponenten gegen die Brechzahl aufgetragen ist.

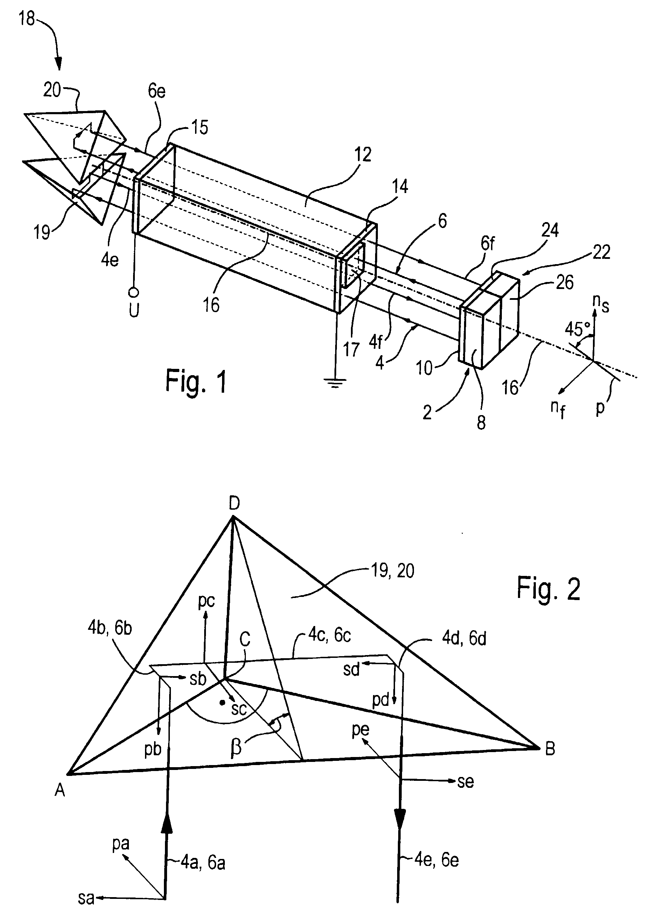

Gemäß FIG 1 umfaßt eine Einrichtung gemäß der Erfindung eine Sendeeinrichtung 2 zum Erzeugen eines ersten linear polarisierten Lichtstrahls 4 und eines zweiten, sich parallel dazu ausbreitenden ebenfalls linear polarisierten zweiten Lichtstrahls 6. Die Sendeeinrichtung 2 umfaßt hierzu eine Lichtquellenanordnung 8 sowie eine Polarisatoranordnung 10 zum Linearpolarisieren des in der Lichtquellenanordnung 8 erzeugten ersten und zweiten Lichtstrahls 4 bzw. 6. Die Lichtquellenanordnung 8 kann hierzu voneinander unabhängige Lichtquellen umfassen. Alternativ kann auch nur eine einzige Lichtquelle vorgesehen sein, aus der mittels einer Strahlteileranordnung zwei Lichtstrahlen erzeugt werden. Des weiteren kann auch eine Lichtquelle vorgesehen sein, die bereits linear polarisiertes Licht erzeugt, so daß die Polarisatoranordnung 10 entfallen kann.

Der erste Lichtstrahl 4 und der zweite Lichtstrahl 6 werden in einen Pockelskristall 12 eingekoppelt, der an seinen zur Ausbreitungsrichtung des ersten Lichtstrahls 4 und des zweiten Lichtstrahls 6 senkrechten Stirnflächen mit optisch transparenten Elektroden 14 und 15 versehen ist. Die auf der der Sendeeinrichtung 2 zugewandten Stirnfläche angeordnete Elektrode 14 ist im Ausführungsbeispiel mit der Gehäusemasse verbunden und die auf der von der Einrichtung 2 abgewandten Stirnfläche angeordnete Elektrode 15 ist an die zu messende Spannung U angeschlossen. Im Ausführungsbeispiel wird somit der longitudinale Pockelseffekt zur Spannungsmessung ausgenutzt. Es sind jedoch auch alternative Anordnungen möglich, bei denen die Ausbreitungsrichtung der ersten und zweiten Lichtstrahlen 4,6 senkrecht zum elektrischen Feld orientiert ist (transversaler Pockelseffekt).

Die Polarisationsebene P der von der Sendeeinrichtung 2 erzeugten linear polarisierten Lichtstrahlen 4 und 6 ist so eingestellt, daß diese unter 45° zu den senkrecht zur optischen Achse 16 orientierten Hauptachsen $n_s, n_f$ des Pockelskristalls 12 liegt.

Im Lichtweg des zweiten Lichtstrahls 6 ist im Ausführungsbeispiel zwischen der Sendeeinrichtung 2 und dem Pockelskristall 12 eine transmissive Phasenschieberanordnung 17 angeordnet, mit der der zweite Lichtstrahl 6 gegenüber dem ersten Lichtstrahl 4 um $\lambda/4$ phasenverzögert wird. Beim Einkoppeln des zweiten Lichtstrahls 6 in den Pockelskristall 12 ist dieser somit nicht mehr linear sondern zirkular polarisiert.

Die Phasenschieberanordnung 17 ist im Ausführungsbeispiel eine $\lambda/4$-Platte. Anstelle einer $\lambda/4$-Platte können jedoch auch im Lichtweg des zweiten Lichtstrahles 6 zwei $\lambda/8$-Platten vorgesehen sein. Alternativ können auch im Lichtweg des ersten Lichtstrahles 4 eine $\lambda/8$-Platte und im Lichtweg des zweiten Lichtstrahles 6 eine hierzu um 90° verdrehte $\lambda/8$-Platte vorgesehen sein.

Der erste und zweite Lichtstrahl 4 bzw. 6 pflanzen sich im Pockelskristall 12 parallel zu seiner optischen Achse 16 fort und treten aus der von der Einrichtung 2 abgewandten Stirnseite des Pockelskristalls 12 aus. Eine hinter dem Pockelskristall 12 befindliche Reflexionsanordnung 18 enthält eine erste und zweite Umlenkeinrichung 19,20, die im Ausführungsbeispiel jeweils aus einem tetraederförmigen Prisma gebildet sind. In den Umlenkeinrichtungen 19,20 werden die aus dem Pockelskristall 12 austretenden Lichtstrahlen 4a bzw. 6a mehrfach derart reflektiert, daß sich die aus den Umlenkeinrichtungen 19 und 20 austretenden Lichtstrahlen 4e bzw. 6e entgegen der Ausbreitungsrichtung der Lichtstrahlen 4 bzw. 6 fortpflanzen und wieder in den Pockelskristall 12 eingekoppelt werden. Die Lichtstrahlen 4e und 6e durchqueren den Pockelskristall 12 erneut und treffen auf eine Empfangseinrichtung 22, die eine Analysatoreinrichtung 24 und eine Detektoranordnung 26 umfaßt, in der die Intensität der aus dem Pockelskristall 12 nach zweimaligem Durchqueren austretenden und von der Analysatoreinrichtung 24 hindurchgelassenen Lichtstrahlen 4e und 6e gemessen wird.

Bei der mehrfachen Reflexion in den Umlenkeinrichtungen 19,20 bleibt die Phasenlage zwischen den beiden parallel zu den Hauptachsen $n_s$ und $n_f$ des Pockelskristalls 12 linearpolarisierten Komponenten der Lichtstrahlen 4a,6a erhalten, d. h. der Polarisationszustand der aus der Umlenkeinrichtung 19,20 austretenden Lichtstrahlen 4e bzw. 6e stimmt jeweils mit dem Polarisationszustand der aus dem Pockelskristall 12 austretenden Lichtstrahlen 4a,6a überein.

Dies wird anhand von FIG 2 näher erläutert. Der aus dem Pockelskristall austretende Lichtstrahl 4a,6a trifft senkrecht auf eine Grenz- oder Grundfläche ABC der aus einem tetraederförmigen Prisma gebildeten Umlenkeinrichtung 19,20 und pflanzt sich innerhalb dieses Prismas bis zu einer weiteren Grenzfläche ARD fort, die unter dem Winkel $\beta_1 = 45°$ gegen die Grundfläche ABC geneigt ist. An dieser weiteren Grenzfläche ARD wird der Lichtstrahl 4a,6a um 90° umgelenkt oder reflektiert. Der reflektierte Lichtstrahl 4b,6b trifft auf eine Grenzfläche ACD die senkrecht auf der Grundfläche ABC steht und mit der Begrenzungsfläche ABD einen Winkel von 45° einschließt, so daß der reflektierte Strahl 4b,6b erneut reflektiert wird.

Die Reflexionsebene der ersten Reflexion, d. h. die durch die Lichtstrahlen 4a,6a und 4b,6b aufgespannte Ebene ist dabei senkrecht zur Reflexionsebene der zweiten Reflexion, d. h. der durch die Lichtstrahlen 4b,6b und 4c,6c aufgespannten Reflexionsebene. Der in der zweiten Reflexion reflektierte Lichtstrahl 4c,6c wird an einer Grenzfläche BCD reflektiert, die senkrecht auf der Grenzfläche ACD und auf der Grundfläche ABC steht, so daß der bei der zweiten Reflexion entstehende Lichtstrahl 4c,6c erneut um 90° umgelenkt wird. Der hierbei entstehende Lichtstrahl 4d,6d trifft nun wieder auf die weitere Grenzfläche ABD und wird dort erneut um 90° umgelenkt. Der auf diese Weise entstehende umgelenkte oder reflektierte Strahl 4e,6e trifft senkrecht auf die Grundfläche ABC auf und tritt aus dem Prisma aus. Die Reflexionsebenen der ersten und vierten Reflexion sind somit parallel zueinander. Ebenso sind die Reflexionsebenen der zweiten und dritten Reflexion parallel zueinander, aber senkrecht zu den Reflexionsebenen der ersten und vierten Reflexionsebene.

Die relative Phasenlage der zueinander senkrecht polarisierten Komponenten sa und pa des auf die Reflexionsanordnung 18,20 einfallenden Lichtstrahls 4a,6a und die relative Phasenlage der zueinander senkrechten Komponenten pe,se des aus der Reflexionsanordnung 18,20 austretenden Lichtstrahles 4e,6e bleibt unverändert. Dies findet seine Ursache darin, daß die in der ersten Reflexion zur Reflexionsebene senkrechten Komponenten sa und sb bzw. die zur ersten Reflexionsebene parallelen Komponenten pa,pb in der zweiten Reflexion zu parallelen bzw. senkrechten Komponenten werden, d. h. für die zweite Reflexion ist die in der ersten Reflexion senkrechte Komponente sb eine parallel zur Reflexionsebene liegende Komponente und die parallel zur ersten Reflexionsebene liegende Komponente pb eine zur zweiten Reflexionsebene senkrechte Komponente. Mit anderen Worten: Durch die gleichwinklige Reflexion in zwei zueinander senkrechten Reflexionsebenen werden die zwischen den aufeinander senkrecht stehenden s- und p-Komponenten entstehenden relativen Phasenveränderungen wieder kompensiert. Dies läßt sich folgendermaßen formalisiert ausdrücken, wobei ein Pfeil eine Reflexion symbolisiert, $\varphi s$, $\varphi p$ die Phasenverschiebung

für eine senkrecht bzw. parallel zur Reflexionsebene orientierte Komponente ist, und das Summenzeichen „+" symbolisch zum Ausdruck bringt, daß die betreffende Komponente eine Phasenverschiebung erfahren hat.

$$sa \rightarrow sb = sa + \varphi s \rightarrow sc = sb + \varphi p = sa + \varphi s + \varphi p$$

$$pa \rightarrow pb = pa + \varphi p \rightarrow pc = pb + \varphi s = pa + \varphi p + \varphi s$$

Wenn somit jeder Reflexion eine weitere Reflexion paarweise zugeordnet ist, deren Reflexionsebenen senkrecht aufeinander stehen und die Reflexionen gleichwinklig erfolgen, ist der aus solchen paarweisen Reflexionen hervorgehende Lichtstrahl in seinem Polarisationszustand gegenüber dem in die Umlenkeinrichtung 19,20 einfallenden Lichtstrahl unverändert.

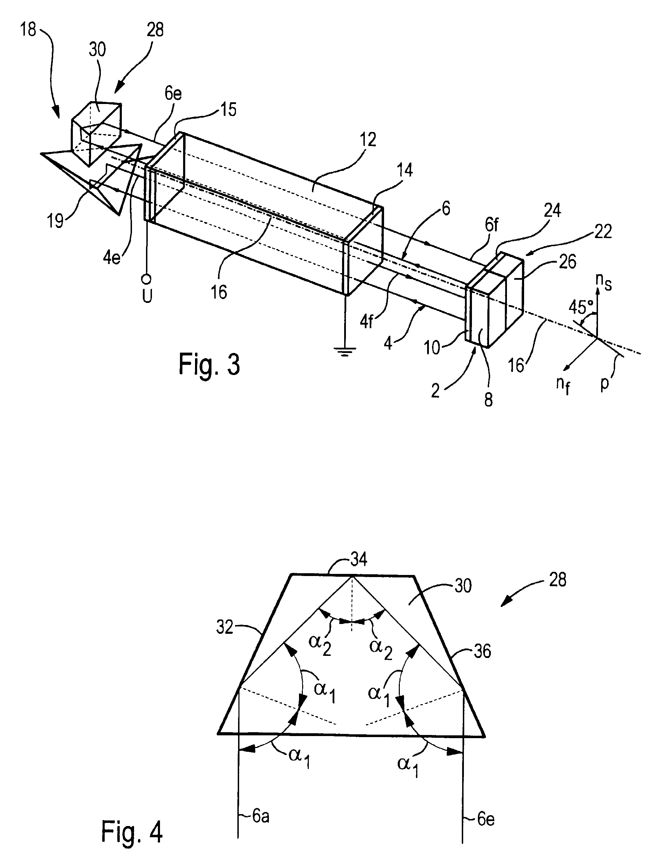

Gemäß FIG 3 ist an Stelle einer λ/4-Verzögerungsplatte 17 gemäß FIG 1 eine reflexive Phasenschieberanordnung 28 vorgesehen, die in der Reflexionsanordnung 18 an der der Sendeeinrichtung 2 abgewandten Stirnfläche des Pockelskristalls 12 angeordnet ist. Im Ausführungsbeispiel besteht die reflexive Phasenschieberanordnung 28 in der Reflexionsebene (Zeichenebene) aus einem im Schnitt trapezförmigen Körper 30, beispielsweise einem Pyramidenstumpf, in dem der aus dem Pockelskristall 12 austretende Lichtstrahl 6a dreimal reflektiert und erneut in den Pockelskristall 12 eingekoppelt wird. Diese Reflexionsebene ist so orientiert, daß sie parallel zu einer der senkrecht zur optischen Achse des Pockelskristalls orientierten Hauptachse ist.

In FIG 4 ist zu erkennen, daß der aus dem Pockelskristall austretende Lichtstrahl 6a an einer ersten Grenzfläche 32 in einem Reflexionswinkel $\alpha_1$, an einer zweiten Grenzfläche 34 um den Winkel $\alpha_2$ und an einer dritten Grenzfläche 36 erneut um den Winkel $\alpha_1$ reflektiert wird, so daß insgesamt eine Umlenkung um 180° stattfindet. Eine solche Umlenkung um 180° findet dann statt, wenn die Beziehung $2\alpha_1 + \alpha_2 = 180°$ erfüllt ist.

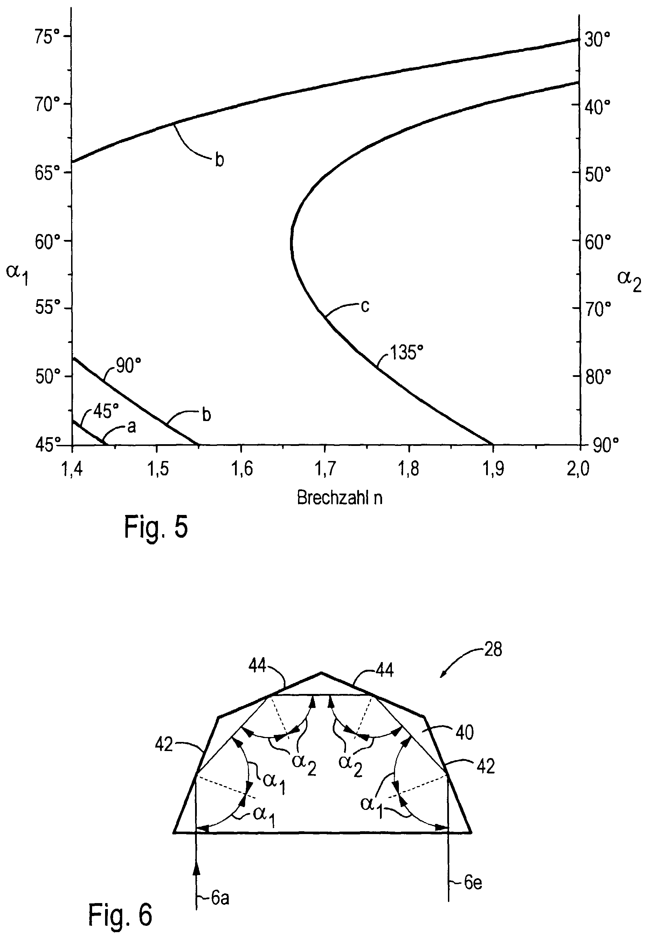

In FIG 5 sind nun für die reflexive Phasenschieberanordnung gemäß FIG 4 Kurven a,b,c mit jeweils gleicher Phasenverzögerung zwischen den senkrecht und parallel zur Reflexionsebene (Zeichenebene) orientierten s- und p-Komponenten des Lichtstrahls 6 für unterschiedliche Brechzahlen n und Reflexionswinkel $\alpha_1,\alpha_2$ aufgetragen. Kurven a,b,c entsprechen jeweils einer Phasenverzögerung von λ/8, λ/4 bzw. 3λ/8. In der Figur ist nun zu erkennen, daß es für einen großen Bereich von Brechzahlen zwischen 1,4 und 1,55 für jede Brechzahl zumindest eine Winkelpaarung α,β gibt, mit der beispielsweise eine Phasenverzögerung von λ/4 eingestellt werden kann.

Im Ausführungsbeispiel gemäß FIG 6 ist als reflexive Phasenschieberanordnung 28 ein fünfflächiger, symmetrischer prismatischer Körper 40 vorgesehen, der sich aus einem im Schnitt trapezförmigen Körper und einem darauf aufgesetzten Prisma zusammensetzt und in dem der aus dem Pockelskristall austretende Lichtstrahl 6a viermal reflektiert wird, wobei an zwei Grenzflächen 42 eine Reflexion um jeweils einen Winkel $\alpha_1$ und an zwei weiteren Grenzflächen 44 jeweils eine Reflexion um einen Winkel $\alpha_2$ stattfindet. Eine Umlenkung um 180° wird dann erreicht, wenn die Beziehung $\alpha_1 + \alpha_2 = 135°$ erfüllt ist.

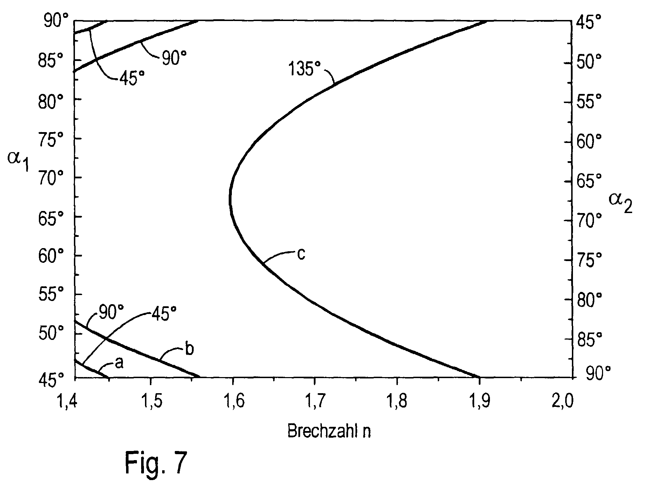

Dem Diagramm gemäß FIG 7 ist auch für das Ausführungsbeispiel gemäß FIG 6 zu entnehmen, daß ein großer Bereich von Brechungsindizes n existiert, in dem für jede Brechzahl n ein Reflexionswinkelpaar $\alpha_1,\alpha_2$ gefunden werden kann, für das eine gewünschte Phasenverzögerung von beispielsweise λ/4 erzielt werden kann. Auch in diesem Ausführungsbeispiel entsprechen die Kurven a,b,c einer Phasenverzögerung von λ/8, λ/4, 3λ/8.

Es hat sich außerdem gezeigt, daß auch unsymmetrische reflexive Phasenschieberanordnungen möglich sind, bei denen alle internen Reflexionswinkel $\alpha_i$ voneinander verschieden sind.

Bei der Verwendung einer solchen unsymmetrischen Phasenschieberanordnung sind die Freiheitsgrade bezüglich der Auswahl des optischen Mediums gegenüber den symmetrischen Phasenschieberanordnungen deutlich erhöht, so daß die Auswahl des geeigneten optischen Mediums im Hinblick auf weitere Parameter, beispielsweise leichte Bearbeitbarkeit, niedrige Eigenabsorption, hohe Spannungsfestigkeit optimiert werden kann.

**Patentansprüche**

1. Verfahren zur Messung einer elektrischen Spannung mit Hilfe des Pockelseffektes, bei dem in einen Pockelskristall (12) zumindest ein erster polarisierter Lichtstrahl (4) eingekoppelt wird, wobei der aus dem Pockelskristall (12) austretende erste Lichtstrahl (4a) durch eine jeweils gleiche Anzahl von rechtwinkligen Reflexionen in paarweise senkrecht zueinander orientierten Reflexionsebenen umgelenkt und erneut in den Pockelskristall (12) eingekoppelt wird.

2. Verfahren nach Anspruch 1, bei dem in den Pockelskristall (12) ein erster und ein zweiter polarisierter Lichtstrahl (4,6) eingekoppelt werden, wobei der erste und der zweite Lichtstrahl (4,6) auf ihrem Lichtweg außerhalb des Pockelskristalls (12) relativ zueinander um ein ungeradzahliges Vielfaches von λ/4 phasenverschoben werden, und wobei der aus dem Pockelskristall (12) austretende erste und zweite Lichtstrahl (4a,6a) durch eine jeweils gleiche Anzahl von rechtwinkligen Reflexionen in paarweise senkrecht zueinander orientierten Reflexionsebenen umgelenkt und erneut in den Pockelskristall eingekoppelt werden.

**3.** Verfahren nach einem der Ansprüche 1 oder 2, bei dem zur Umlenkung des ersten Lichtstrahles (4) in jeder Reflexionsebene zwei Reflexionen vorgesehen sind.

**4.** Verfahren nach einem der Ansprüche 1 bis 3, bei dem die Umlenkung des ersten Lichtstrahles (4) durch innere Totalreflexion erfolgt.

**5.** Verfahren nach Anspruch 1, bei dem in den Pockelskristall (12) ein erster und ein zweiter polarisierter Lichtstrahl (4,6) eingekoppelt werden, wobei der zweite Lichtstrahl (6) auf seinem Lichtweg außerhalb des Pockelskristalls (12) durch innere Totalreflexion um ein ungeradzahliges Vielfaches von $\lambda/4$ phasenverschoben wird.

**6.** Einrichtung zur Messung einer elektrischen Spannung mit Hilfe des Pockelseffektes, mit einem Pockelskristall (12) und einer diesem vorgeschalteten Sendeeinrichtung (2) zum Erzeugen wenigstens eines ersten polarisierten Lichtstrahls (4), wobei in Ausbreitungsrichtung des Lichtstrahles (4) gesehen hinter dem Pockelskristall (12) eine Reflexionsanordnung (18) zum Umlenken und erneuten Einkoppeln des aus dem Pockelskristall (12) austretenden Lichtstrahles (4a) vorgesehen ist, die eine Umlenkeinrichtung (19,20) zur Reflexion des Lichtstrahles (4a) in einer jeweils gleichen Anzahl von gleichwinkligen Reflexionen in paarweise senkrecht zueinander orientierten Reflexionsebenen umfaßt.

**7.** Einrichtung nach Anspruch 6, mit einer dem Pockelskristall (12) vorgeschalteten Sendeeinrichtung (2) zum Erzeugen eines ersten und eines zweiten polarisierten Lichtstrahls (6) und mit einer transmissiven Phasenschieberanordnung (17) zum Erzeugen einer Phasenverschiebung zwischen dem ersten und zweiten Lichtstrahl (4,6) um ein ungeradzahliges Vielfaches von $\lambda/4$, wobei die in Ausbreitungsrichtung der Lichtstrahlen (4,6) gesehen hinter dem Pockelskristall (12) angeordnete Reflexionsanordnung (18) eine erste und eine zweite Umlenkeinrichtung (19,20) zum Umlenken des aus dem Pockelskristall austretenden ersten bzw. zweiten Lichtstrahls (4a,6a) durch eine jeweils gleiche Anzahl von gleichwinkligen Reflexionen in paarweise senkrecht zueinander orientierten Reflexionsebenen und deren erneuten Einkoppeln in den Pockelskristall (12) umfaßt.

**8.** Einrichtung nach Anspruch 7, mit einer dem Pockelskristall (12) vorgeschalteten Sendeeinrichtung (2) zum Erzeugen eines ersten und zweiten polarisierten Lichtstrahls (6) und mit einer in Ausbreitungsrichtung der Lichtstrahlen (4, 6) gesehen hinter dem Pockelskristall (12) in der Reflexionsanordnung (18) angeordneten reflexiven Phasenschieberanordnung (30,40) zum Erzeugen einer ein ungeradzahliges Vielfaches von $\lambda/4$ betragenden Phasenverschiebung des zweiten Lichtstrahles (6) durch eine mehrfache innere Totalreflexion des aus dem Pockelskristall (12) austretenden zweiten Lichtstrahles (6a).

**9.** Reflexionsanordnung zur polarisationserhaltenden Umlenkung eines Lichtstrahles um 180°, insbesondere für die Verwendung bei der Messung einer elektrischen Spannung mit Hilfe des Pockelseffektes nach einem der vorhergehenden Ansprüche, mit einer Umlenkeinrichtung (19,20) zur Reflexion des Lichtstrahles (4a) in einer jeweils gleichen Anzahl von gleichwinkligen Reflexionen in paarweise senkrecht zueinander orientierten Reflexionsebenen.

**10.** Reflexionsanordnung nach Anspruch 6, bei der als Umlenkeinrichtung (19,20) ein tetraederförmiges Prisma mit drei zueinander senkrechten und sich in einem Punkt schneidenden Grenzflächen (ABC,ACD,BCD) und einer zu diesen ersten Grenzflächen unter 45° orientierten weitere Grenzfläche (ABD) vorgesehen ist.

Fig. 1

Fig. 2

Fig. 3

Fig. 4

Fig. 5

Fig. 6

Fig. 7